# EUROPEAN PATENT APPLICATION

(11) **EP 3 624 168 A1**
(43) Date of publication of application: **18.03.2020**
(21) Application number: 18797843.2
(22) Date of filing: 18.04.2018
(51) Int. Cl.: H01L 21/02, B05D 3/12, B32B 37/00, H01L 21/683

(54) **ADHESIVE AGENT LAYER FORMING DEVICE, SEMICONDUCTOR CHIP MANUFACTURING LINE, AND LAMINATED BODY MANUFACTURING METHOD**

(30) Priority: 12.05.2017 JP 2017095585
(71) Applicant: Daicel Corporation, Osaka-shi, Osaka 530-0011 (JP)
(72) Inventor: FUNAKI, Yoshinori, Himeji-shi Hyogo 671-1283 (JP); TSUJI, Naoko, Himeji-shi Hyogo 671-1283 (JP)
(74) Representative: Grünecker Patent- und Rechtsanwälte PartG mbB
(86) International application number: PCT/JP2018/016038
(87) International publication number: WO 2018/207575

(57) **Abstract**

Provide are: a method for producing a laminate having an adhesive layer on one surface of a semiconductor wafer, with the adhesive layer being less likely to foam during wafer bonding under reduced pressure, curing of an adhesive being less likely to occur, and also allowing a tact time to be shortened; and an adhesive layer forming device to be used in the method. The adhesive layer forming device for forming an adhesive layer by removing a solvent in a coating film coated and formed on one surface of a semiconductor wafer includes: a lower plate on which the semiconductor wafer is placed; an upper cover configured to form a closed space together with the lower plate, the closed space having a volume of 10 liters or less; and pressure reducing means for reducing pressure in the closed space.

## Description

### Technical Field

The present invention relates to an adhesive layer forming device, a semiconductor chip production line, and a method for producing a laminate. More specifically, the present invention relates to a device (adhesive layer forming device) for forming an adhesive layer on at least one surface of a semiconductor wafer, a semiconductor chip production line including the adhesive layer forming device, and a method for producing a laminate having an adhesive layer on at least one surface of a semiconductor wafer. The present application claims priority to JP 2017-095585 filed to Japan on May 12, 2017, content of which is incorporated herein.

### Background Art

In production of a laminated semiconductor chip, silicon wafers are stacked and laminated together by an adhesive. In particular, in a wafer-on-wafer method (WOW method), a silicon wafer on which a transistor circuit is formed is not cut into a shape of a chip, and is laminated via an adhesive in wafer units.

In the WOW method described above, there is a concern that air is involved (bubble inclusion) when silicon wafers are laminated together, and therefore pressure bonding and heating are ordinarily performed under reduced pressure (in particular, under vacuum) (for example, see Non-Patent Literature 1). In that case, if a solvent remains in the adhesive, the solvent vaporizes and foams under reduced pressure, and a phenomenon similar to bubble inclusion occurs, which may result in adhesion failure of the wafers. Therefore, the solvent in the adhesive coated on the wafers is required to be sufficiently removed (desolventization), and normally the adhesive is desolventized by heating the adhesive to a temperature near the boiling point of the solvent (for example, approximately 140°C) under atmospheric pressure condition, by, for instance, extending the heating time (for example, see Patent Document 1).

### Citation List

### Patent Document

Patent Document 1: Japanese Patent No. 5693961

### Non-Patent Literature

Non-Patent Literature 1: "Report on Research and Development Results of Development of Technology for Precise Mounting of Composite Wafer for Power Device", [online], December, 2012, The New Industry Research Organization, [Searched on May 12, 2017], Internet URL: http://www.chusho.meti.go.jp/keiei/sapoin/portal/seika/2010/22152803010.pdf >

### Summary of Invention

### Technical Problem

However, in the method for implementing heating to a temperature near the boiling point of the solvent under atmospheric pressure condition, the adhesive component in the adhesive is required to be not cured during the heating. Thus, there is a necessity of selecting: an adhesive having a curing temperature higher than the boiling point of the solvent under atmospheric pressure condition; a dissolvent having a low boiling point under atmospheric pressure condition; a curing adhesive that does not cause such a problem, or the like, and there is a problem in that the choice of adhesive or solvent to be used is limited. Meanwhile, extending the heating time means a longer time for the production process ("tact time", which is actual work time taken for each product in a production process concerned).

It is conceivable to use a vacuum dryer to solve this problem. However, many commercially available vacuum dryers generally have a cubic chamber shape, hence as the wafer size increases, the entire size of the dryer has to become larger (for example, see Non-Patent Literature 1). If the vacuum dryer is large, there is a problem in that the time for reducing the pressure in the vacuum dryer and the time for returning the pressure to the ordinary pressure become longer, and moreover uniform temperature control in the vacuum dryer under reduced pressure becomes more difficult. As a result, there has been a problem that the effect of shortening the "tact time" is not remarkably exhibited when commercially available vacuum dryers are used.

Therefore, an object of the present invention is to provide a method for producing a laminate having an adhesive layer on one surface of a semiconductor wafer, with the adhesive layer being less likely to foam during wafer bonding under reduced pressure, curing of an adhesive component (that is, curing of adhesive) being less likely to occur, and also allowing a tact time to be shortened, and to provide an adhesive layer forming device to be used in the method. Another object of the present invention is to provide a semiconductor chip production line including the adhesive layer forming device described above.

### Solution to Problem

As a result of intensive study directed at solving the above problems, the present inventors found out that by forming an adhesive layer through desolventizing of a coating film, formed by coating an adhesive composition, under reduced pressure in a closed space having a specific volume or less, it is possible to produce a semiconductor wafer having an adhesive layer which is less likely to foam during wafer bonding under reduced pressure, with curing of the adhesive less likely to occur, and also allowing the tact time to be shortened. The present invention has been completed based on these findings.

That is, the present invention provides an adhesive layer forming device for forming an adhesive layer by removing a solvent in a coating film coated and formed on one surface of a semiconductor wafer, and the device includes: a lower plate on which the semiconductor wafer is placed; an upper cover configured to form a closed space together with the lower plate, the closed space having a volume of 10 liters or less; and pressure reducing means for reducing pressure in the closed space.

In the adhesive layer forming device, a portion of the upper cover preferably has a dome shape, the portion serving as a ceiling of the closed space.

In the adhesive layer forming device, a dome shaped part of the upper cover is preferably made of metal, and a thickness of the dome shaped part is preferably 2 mm or less.

The adhesive layer forming device preferably includes heating means for heating the coating film.

In the adhesive layer forming device: the upper cover preferably includes a flange part on a circumference of the upper cover; and the lower plate preferably includes a placing stand on which the semiconductor wafer is placed, and a groove provided around the placing stand and configured to contact the flange part thereby form the closed space.

The adhesive layer forming device preferably includes a thermocouple at a position, where ventilation from the closed space is blocked, within the lower plate.

The adhesive layer forming device further preferably includes a vertical drive unit including a hook unit and a ball unit, the vertical drive unit being configured to move the upper cover vertically to open and close the closed space. The upper cover is preferably coupled to a branch pipe coupled to the pressure reducing means and pressure releasing means for returning pressure in the closed space to ordinary pressure.

In the adhesive layer forming device, the upper cover preferably includes a gas inflow guard configured to prevent gas, which flows into the closed space when the pressure in the closed space is returned to ordinary pressure, from blowing directly against a surface of the formed adhesive layer, the inflow guard being provided at an inner side of a portion, where the gas flows in, of the upper cover.

In the adhesive layer forming device, the hook unit is preferably coupled to a jack via an arm.

Furthermore, the present invention provides a semiconductor chip production line including: in the following order, an adhesive composition coating device for coating, on one surface of a semiconductor wafer, an adhesive composition containing an adhesive component and a solvent thereby forming a coating film; the adhesive layer forming device; and a device configured to laminate together the semiconductor wafer having the adhesive layer formed thereon and another semiconductor wafer.

Furthermore, the present invention provides a method for producing a laminate having an adhesive layer on at least one surface of a semiconductor wafer. The method includes: coating, on one surface of a semiconductor wafer, an adhesive composition containing an adhesive component and a solvent thereby forming a coating film; and forming an adhesive layer by removing a solvent in the coating film in a closed space having a volume of 10 liters or less under reduced pressure.

Furthermore, the present invention provides a method for producing a laminate having an adhesive layer on at least one surface of a semiconductor wafer. The method includes: coating, on one surface of a semiconductor wafer an adhesive composition containing an adhesive component and a solvent thereby forming a coating film; and forming an adhesive layer by removing a solvent in the coating film by using the adhesive layer forming device.

### Advantageous Effects of Invention

According to the adhesive layer forming device of the present invention and the production method of the present invention, the configuration described above enables production of a laminate having an adhesive layer on one surface of a semiconductor wafer, with the adhesive layer being less likely to foam during wafer bonding under reduced pressure, curing of the adhesive being less likely to occur, and also allowing a tact time to be shortened.

### Brief Description of Drawings

FIG. 1 is a schematic view (front cross-sectional view) illustrating an example of an adhesive layer forming device of the present invention.
FIG. 2A is a top view of an upper cover 2 including a dome shaped part 2a and a flange part 2b, and FIG. 2B is a cross-sectional front view taken along b-b'in FIG. 2A.
FIG. 3A is a top view of a lower plate 1, and FIG. 3B is a cross-sectional front view taken along b-b' in FIG. 3A.
FIG. 4 is a schematic view illustrating an example in which a hook unit 4b of a vertical drive unit 4 and a jack 6a are coupled via an arm 6b.
FIG. 5A is a front view of a state where the vertical drive unit 4 is coupled to the arm 6b, FIG. 5B is a cross-sectional side view taken along b-b' in FIG. 5A, and FIG. 5C is a cross-sectional top view taken along c-c' in FIG. 5A.
FIG. 6 is a schematic view illustrating a process of forming an adhesive layer by using the adhesive layer forming device of the present invention.
FIG. 7 is a schematic view illustrating a mode in which a heating plate 8 is provided below the lower plate 1.
FIG. 8 is an enlarged view (perspective view) of a gas inflow guard 2d.
FIG. 9A is a schematic view (top view) illustrating a mode before and after conveying, by conveying means, a semiconductor wafer from an adhesive composition coating device to the adhesive layer forming device of the present invention, and FIG. 9B is a schematic view (top view) illustrating a mode before and after conveying, by the conveying means, a semiconductor wafer from the adhesive layer forming device of the present invention to a semiconductor wafer laminating device.
FIG. 10A is a top view of a pickup jig, and FIG. 10B is a left side view thereof.

### Description of Embodiments

### [Adhesive layer forming device]

An adhesive layer forming device according to an embodiment of the present invention is a device (adhesive layer forming device) for forming an adhesive layer by removing a solvent (dissolvent) in a coating film coated and formed on one surface of a semiconductor wafer. The adhesive layer forming device according to the embodiment of the present invention includes a lower plate on which a semiconductor wafer is placed, an upper cover configured to form, together with the lower plate, a closed space having a volume of 10 liters or less, and pressure reducing means configured to reduce pressure in the closed space.

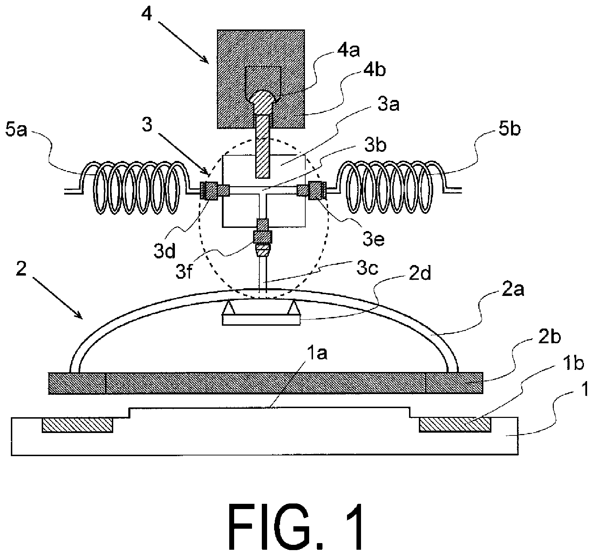

FIG. 1 is a schematic view (front cross-sectional view) illustrating an example of the adhesive layer forming device of according to an embodiment the present invention. The adhesive layer forming device according to the embodiment of the present invention illustrated in FIG. 1 includes a board-like lower plate 1 and an upper cover 2. When the upper cover 2 is moved downwards and brought into contact with the lower plate 1, a closed space having a volume of 10 liters or less can be formed between the upper cover 2 and the lower plate 1. Furthermore, the closed space is formed and opened by vertical movement of the upper cover 2, and thus, installation of an opening/closing door is not required.

The volume of the closed space formed by the upper cover 2 and the lower plate 1 is 10 liters or less (for example, 0.1 to 10 liters) as described above, preferably 8 liters or less (for example, 0.1 to 8 liters), and more preferably 7 liters or less (for example, 0.1 to 7 liters).

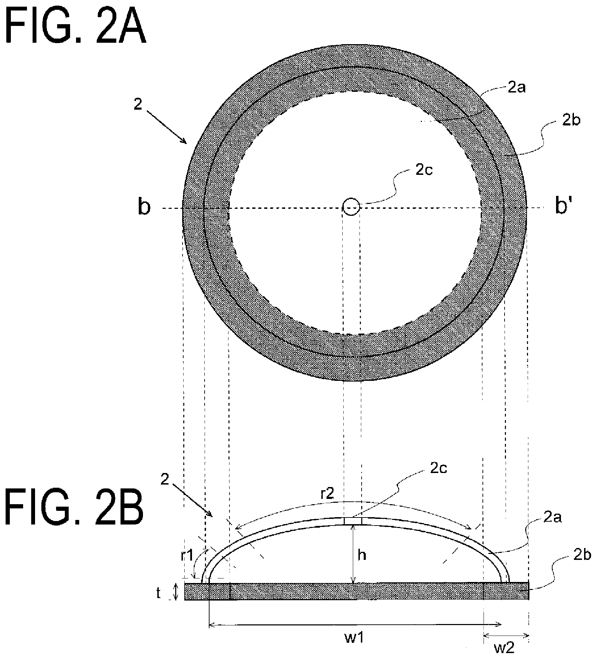

The upper cover 2 has a portion having a dome shape (bowl shape) that serves as a ceiling of the closed space, and includes a dome shaped part 2a having a dome shape and a flange part 2b. FIG. 2 illustrates a top view (FIG. 2A) of the upper cover 2 including the dome shaped part 2a and the flange part 2b, and a cross-sectional front view (FIG. 2B) taken along b-b' in the top view (FIG. 2A). As illustrated in FIG. 2, the upper cover 2 includes the dome shaped part 2a having a round shape at the center thereof when viewed from above. At the center of a round portion of the domed shape part 2a, a hole 2c is provided to suck gas in the closed space thereby reducing pressure, and on the circumference of the dome shaped part 2a, the flange part 2b is provided along the periphery thereof. The upper cover 2 is has a dome shape, and in the present specification, the "dome shape" refers to a shape, in which an angle from a cross-sectional horizontal plane toward outside from the center (hole 2c) when viewed from above gradually increases, and in which the center of the round portion when viewed from the cross-sectional front (for example, FIG. 2B) has a gently convex shape; thus, the above shape includes a hemispherical shape and a semi-ellipse spherical shape. Since the upper cover 2 has a dome shape, when a closed space is formed by the upper cover 2 and the lower plate 1, the closed space has a sufficient space for installing a semiconductor wafer having a thickness of slightly less than 1 mm and having a minimized internal volume. Note that in the adhesive layer forming device according to the embodiment of the present invention, the shape of the upper cover 2 is not limited to a dome shape, and may have other shapes as long as the closed space having a specific volume or less described above can be formed.

As illustrated in FIG. 2B, in the dome shaped part 2a, a near-edge area of the dome shape (an area near the flange part 2b) r1 and a near-bottom area of the dome shape (an area near the hole 2c) r2 have curvatures different from each other, and a curvature radius of the near-bottom area r2 is greater than a curvature radius of the near-edge area r1. The curvature radius of the near-edge area r1 is preferably R = 20 to 40. The curvature radius of the near-bottom area r2 is preferably R = 250 to 400. In addition, for easier desolventization of the coating film, a height h from the bottom inside the dome shape to the edge of the dome shape is preferably 50 to 120 mm. The diameter w1 of an edge surface inside the dome shape is preferably slightly larger than the size of the semiconductor wafer, and may be, for example, 100 to 500 mm. In the flange part 2b, a difference (width of the flange part 2b) w2 between the diameter of the circle having the inner edge as a circumference thereof and the diameter of the circle having the outer edge as a circumference thereof is preferably 5 to 30 mm. The thickness t of the flange part 2b is preferably 3 to 20 mm. The thickness of the dome shaped part 2a is preferably 5 mm or less, and more preferably 2 mm or less, from the perspective of weight reduction.

The material of the dome shaped part 2a of the upper cover 2 includes metal, resin, glass, and the like, and from the perspective of weight reduction and strength relative to pressure reduction in the closed space, metal is preferable, and SUS is particularly preferable. That is, the dome shaped part 2a is preferably made of metal and is particularly preferably made of SUS.

With the adhesive layer forming device according to the embodiment of the present invention, a recess due to a difference between atmospheric pressure and reduced pressure in the closed space can be prevented even if the dome shaped part 2a of the upper cover 2 is produced by performing curved-surface processing on a thin metal plate. In addition, when a dome shaped part 2a like this is employed, the weight of the upper cover 2 can be reduced, and power and a mechanism required for vertical movement of the upper cover 2 can be also minimized.

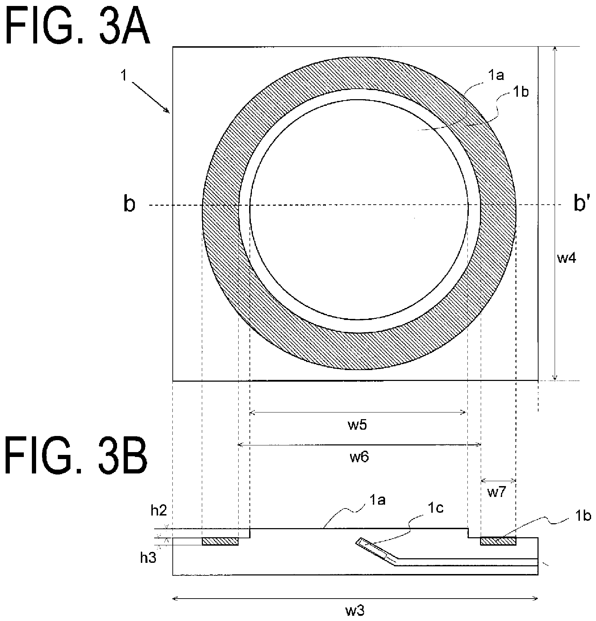

In the adhesive layer forming device according to the embodiment of the present invention illustrated in FIG. 1, the lower plate 1 has a rectangular shape when viewed from the top, and includes a placing stand 1a at the center thereof to place thereon a semiconductor wafer having a coating film formed thereon. In addition, the lower plate 1 includes, around the placing stand 1a, a groove 1b that contacts the flange part 2b of the upper cover 2 (in particular, the bottom part of the flange part 2b) to form a closed space. FIG. 3 illustrates a top view (FIG. 3A) of the lower plate 1, and a cross-sectional front view (FIG. 3B) taken along b-b' in the top view (FIG. 3A). The placing stand 1a has a circular shape and extends higher than other portions, and the groove 1b is provided in a ring shape around the placing stand 1a. The upper cover 2 includes the flange part 2b and the lower plate 1 includes the groove 1b respectively, whereby since the upper cover 2 and the lower plate 1 come into contact with each other at the flange part 2b and the groove 1b when forming the closed space, the adhesion between the upper cover 2 and the lower plate 1 is enhanced, and air is less likely to flow into the closed space under reduced pressure. Note that in the adhesive layer forming device according to the embodiment of the present invention, the lower plate 1 may not need to include the groove 1b, and the upper cover 2 may not need to include the flange part 2b. The adhesive layer forming device according to the embodiment of the present invention includes heating means (not illustrated). A thermocouple 1c is embedded within the lower plate 1 at a position where ventilation from the formed closed space is blocked. Accordingly, the lower plate 1 is provided with a hole in which the thermocouple 1c is installed. When the thermocouple 1c is used, the temperature at a point closer to the semiconductor wafer can be measured.

In the lower plate 1 illustrated in FIG. 3, a width w3 and a length w4 of the lower plate 1 each are in a range from 200 to 600 mm, for example, depending on the size of the semiconductor wafer with the coating film formed thereon. A diameter w5 of the placing stand 1a is preferably slightly smaller than the size of the semiconductor wafer from the perspective of minimizing the volume of the closed space and facilitating the placing and pickup of the semiconductor wafer, and is in a range from 80 to 470 mm for example. In the groove 1b, a diameter w6 of the circle having the inner edge as a circumference thereof is preferably larger than that of w5 but smaller as long as no contact thereof with the semiconductor wafer is ensured. In the groove 1b, a difference (width of the groove 1b) w7 between the diameter w6 of the circle having the inner edge as a circumference thereof and the diameter of the circle having the outer edge as a circumference thereof is preferably slightly larger than the width w2 of the flange part 2b, and is in a range from 12 to 60 mm, for example. The height h2 of the placing stand 1a is preferably in a range from 5 to 20 mm. The depth h3 of the groove 1b is preferably in a range from 1 to 10 mm.

The material of the lower plate 1 includes metal, resin, glass, and the like, and from the perspective of strength relative to pressure reduction in the closed space and thermal conductivity, metal is preferable, and SUS is particularly preferable. That is, the lower plate 1 is preferably made of metal and is particularly preferably made of SUS.

In addition, the bottom of the flange part 2b and the surface of the groove 1b are subjected, in pair, to surface processing for adherence by lapping or the like. As a result, even when a sealing agent such as a grease for vacuum is not used, the flange part 2b and the groove 1b can come into contact with each other with no gap, and air is less likely to flow into the closed space under reduced pressure. Furthermore, when the upper cover 2 is brought into contact with the lower plate 1 to form a closed space, only a light load has to be applied in an early stage whereby the flange part 2b of the upper cover 2 comes into close contact with the lower plate 1 due to its own weight of the upper cover 2 and atmospheric pressure; thus, the pressure of 300 mmHg or less can be maintained. Note that when further reduction of pressure is required, a sealing agent, such as a silicone grease, may be applied or a packing, such as a Teflon sheet, may be set to the bottom of the flange part 2b or the like.

In the adhesive layer forming device according to the embodiment of the present invention illustrated in FIG. 1, the upper cover 2 is suspended from a tube branching unit 3. A pipe 3c communicating with a branch pipe 3b coupled to pressure reducing means and means for returning pressure to ordinary pressure (pressure releasing means), is inserted into the hole 2c of the upper cover 2, and the pressure of the closed space is reduced and released via the pipe 3c. The pipe 3c and the upper cover 2 are welded, and thus air does not flow into the closed space when the pressure is reduced. Note that, unlike the illustration in in FIG. 2, the hole 2c does not have to be provided at the center of the dome shape of the upper cover 2, and may be provided at any location of the upper cover 2, but, with the upper cover 2 being suspended, provision at the center of the dome shape is preferable from the perspective of enabling reduction and release of the pressure through the inside of the tube branching unit 3, which suspends the upper cover 2.

The tube branching unit 3 includes the branch pipe 3b within a unit main body 3a. The unit main body 3a includes three female thread parts to which tube joints 3d, 3e, and 3f (for example, one-touch joints) having male thread parts are screwed, and three ends of the branch pipe 3b are coupled to the tube joints 3d, 3e, and 3f, respectively. The pipe 3c is coupled to one end of the branch pipe 3b via the tube joint 3f, and the pipe 3c is inserted into the hole 2c of the upper cover 2. Another end of the branch pipe 3b is coupled to a spiral tube 5a coupled to the pressure reducing means (not illustrated) via the tube joint 3d, and the other end of the branch pipe 3b is coupled to a spiral tube 5b coupled to the pressure releasing means (not illustrated) via the tube joint 3e. When the spiral tubes 5a and 5b are used, the free vertical movement of the upper cover 2 is not prevented and the vertical movement can be performed smoothly. The pressure releasing means may communicate with the atmosphere via an air filter for preventing dust invasion, for example.

The tube branching unit 3 is moved vertically by a vertical drive unit 4 including a ball unit 4a and a hook unit 4b. In particular, the tip of a bar part of the ball unit 4a serves as a male thread part, and the male thread part is fixed by screwing into the female thread part of the unit main body 3a of the tube branching unit 3, and thus when the hook unit 4b is lifted up, a ball part of the ball unit 4a is hooked on a hook, then the tube branching unit 3 and the upper cover 2 are lifted (state illustrated in FIG. 1). On the other hand, when the hook unit 4b is lowered, the tube branching unit 3 and the upper cover 2 descend until the upper cover 2 contacts the lower plate 1 and the upper cover 2 does descend any more, then the ball part caught on the hook is separated from the hook, and the flange part 2b of the upper cover 2 fits into the groove 1b of the lower plate 1 only by its own weight, whereby a closed space is formed by the lower plate 1 and the upper cover 2. Therefore, the upper cover 2 can be moved vertically by moving the vertical drive unit 4 vertically, and thus opening and closing operation for the closed space can be implemented. Note that when the adhesive layer forming device according to the embodiment of the present invention is not in use, the upper cover 2 may be in a state of being lifted as illustrated in FIG. 1, but normally the flange part 2b is in a state of being fitted into the groove 1b of the lower plate 1.

The hook unit 4b of the vertical drive unit 4 is coupled to an arm coupled to a jack, the hook unit 4b is moved vertically by moving the arm vertically by the jack, whereby the vertical drive unit 4 is driven vertically.

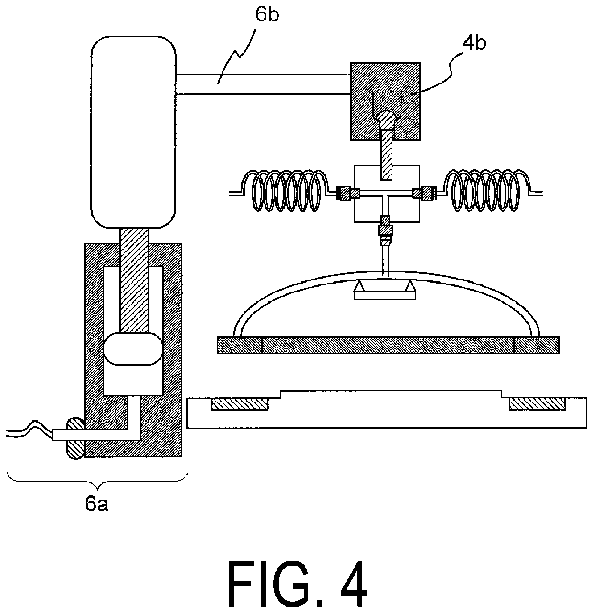

As illustrated in FIG. 4, the hook unit 4b of the vertical drive unit 4 and a jack 6a are coupled to each other via an arm 6b. When the arm 6b is raised by the jack 6a, the vertical drive unit 4 rises, and when the arm 6b is lowered by the jack 6a, the vertical drive unit 4 descends. Note that in the adhesive layer forming device according to the embodiment of the present invention, the driving of the vertical drive unit 4 is not particularly limited as long as the unit can be driven vertically, and may be driven vertically by means other than a jack.

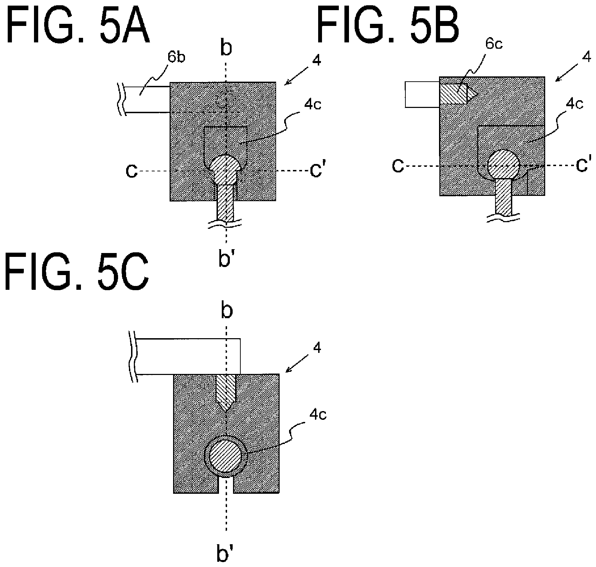

FIG. 5 illustrates a front view (FIG. 5A) of a state where the vertical drive unit 4 is coupled to the arm 6b, a cross-sectional side view (FIG. 5B) taken along b-b' in FIG. 5A, and a cross-sectional top view (FIG. 5C) taken along c-c' in FIG. 5A. In the hook unit 4b, a cavity 4c having a curved bottom is formed near the center of the hook unit 4b, and the ball unit 4a is fixed in the cavity 4c without adhering to the hook unit 4b. In addition, the cavity 4c includes, at a front thereof, a guard to prevent the ball part from falling toward the front side, and includes, at the front, a columnar gap to allow the ball unit 4a to be easily attached to and removed from the hook unit 4b, with the columnar gap being thinner than the diameter of the ball part and thicker than the cross-sectional diameter of the bar part of the ball unit 4a.

With the vertical drive unit 4 having such a structure, when the upper cover 2 moves vertically, the upper cover 2 can move relatively freely, with the ball part of the ball unit 4a serving as a fulcrum. After the upper cover 2 is lowered to be into contact with the lower plate 1, the ball unit 4a is separated from the hook unit 4b, the flange part 2b of the upper cover 2 fits into the groove 1b of the lower plate 1 only by its own weight, whereby the closed space is formed. Then, after the desolventization of the coating film is performed and the pressure reduction in the closed space is canceled, the closed space is opened by only pulling up the ball unit 4a by the hook unit 4b, and the semiconductor wafer having the adhesive layer formed thereon can be removed. In addition, the arm 6b is fixed to a rear portion of the hook unit 4b by an attaching screw 6c.

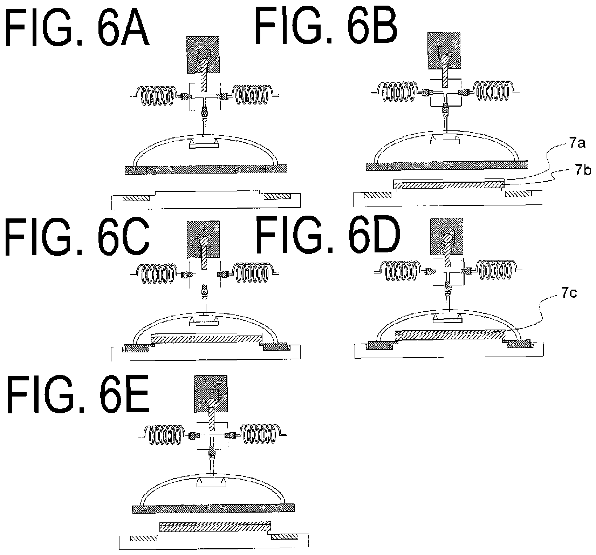

With reference to FIG. 6, a process of forming an adhesive layer by using the adhesive layer forming device according to the embodiment of the present invention will be described. FIG. 6A illustrates a state in which the tube branching unit 3 and the upper cover 2 are lifted by the vertical drive unit 4 and a closed space is not formed (same as the state illustrated in FIG. 1). In this state, a semiconductor wafer 7b having a coating film 7a formed thereon by coating an adhesive composition is placed on the placing stand 1a of the lower plate 1 (FIG. 6B). Note that area of the placement surface of the placing stand 1a is slightly smaller than area of the bottom surface of the semiconductor wafer 7b.

Next, the hook unit 4b is lowered until the flange part 2b of the upper cover 2 contacts the groove 1b of the lower plate 1 and the ball part of the ball unit 4a is separated from the hook of the hook unit 4b, whereby a closed space is formed (FIG. 6C). Note that inside the formed closed space, the semiconductor wafer 7b having the coating film 7a formed thereon is placed on the placing stand 1a. Then, through the pipe 3c, the branch pipe 3b, and the spiral tube 5a, the pressure is reduced from the hole 2c by the pressure reducing means (not illustrated), whereby the inside of the closed space has a specific pressure.

The pressure in the closed space after the pressure reduction, that is, the pressure inside the closed space after desolventization, is not particularly limited, but the pressure is preferably 0 to 300 mmHg, more preferably 0 to 50 mmHg, and even more preferably 0 to 10 mmHg. When the pressure is 300 mmHg or less (preferably 150 mmHg, in particular 100 mmHg or less), even if a solvent having a high boiling point (for example, a boiling point exceeding 100°C under atmospheric pressure condition) is contained in the coating film, the desolventization proceeds efficiently in a state where curing of the adhesive is much less likely to occur.

In the above-described reduced pressure state, the coating film 7a is heated by heating means (not illustrated), the solvent in the coating film 7a is volatilized to implement desolventization, whereby an adhesive layer 7c is formed (FIG. 6D). Note that the coating film 7a may not be heated when the desolventization proceeds sufficiently without heating due to the sufficient reduction of pressure in the closed space. Then, through the pipe 3c, the branch pipe 3b, and the spiral tube 5b, the pressure is released from the hole 2c by the pressure releasing means (not illustrated), and thus, the inside of the closed space has ordinary pressure. Then, the hook unit 4a is lifted up to raise the upper cover 2, and this causes the semiconductor wafer 7b having the adhesive layer 7c formed thereon to be in a movable state (FIG. 6E). Note that a gas inflow guard 2d configured to prevent gas that flows into the closed space from the hole 2c, when the closed space is returned to the ordinary pressure, from blowing directly against the surface of the formed adhesive layer, is provided by being welded at the inner side of a portion from which gas flows in (that is, at the inner side of the dome shaped part 2a in a portion where the hole 2c of the upper cover 2 is provided).

The temperature of the coating film during the desolventization is not particularly limited, but is preferably 80°C or lower (for example, 10 to 80°C), and more preferably 60°C or lower. When the temperature is 80°C or lower, the coating film can be desolventized efficiently, with curing of the adhesive being much less likely to occur. When the temperature is 10°C or higher, the desolventization proceeds efficiently even when a solvent having a high boiling point is contained in the coating film (in the adhesive composition). Note that the temperature of the coating film can be set within the above described range by heating the coating film using the heating means, as appropriate.

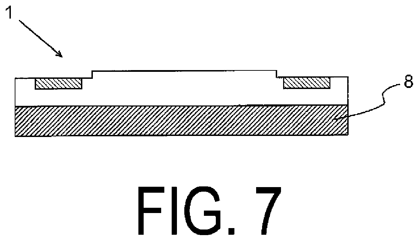

The heating means is not particularly limited as long as it is capable of heating the coating film, but examples of which include a mode in which a heating plate 8 is provided below the lower plate 1, as illustrated in FIG. 7 (i.e., a mode in which the heating plate 8 is heating means), a mode in which heating means is embedded within the lower plate 1 (i.e., a mode in which the lower plate 1 also serves as heating means), and the like. Thus, the heating means may be integral with the lower plate 1 and may be separated from the lower plate 1.

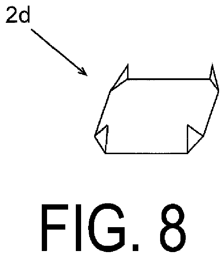

FIG. 8 illustrates an enlarged view (perspective view) of the gas inflow guard 2d. The gas inflow guard 2d has a shape in which four corners of a square are bent to form triangles respectively, and the tips of triangles at the four corners are welded to the inner side of the dome shaped part 2a. Note that the shape of the gas inflow guard 2d is not particularly limited, and may be circular, elliptical, or polygonal. In addition, the shape of the corners to be bent is not limited to triangle. When the gas inflow guard 2d is provided, gas flowing into the closed space from the hole 2c, when the pressure is released, flows into the closed space, from a slit-like gap between welding points formed by the upper cover 2 and the gas inflow guard 2d, along the inner wall surface of the upper cover 2 as a gas stream parallel to the surface of the lower plate 1, and thus, the gas will not blow directly against the surface of the formed adhesive layer. The height of the slit-like gap (height from the bottom surface of the gas inflow guard 2d to the inner wall of the upper cover 2) is, for example, approximately 0.5 to 3 mm, and preferably approximately 0.7 to 1.5 mm.

Note that an example of the adhesive layer forming device according to the embodiment of the present invention has been described with reference to FIG. 1 to FIG.8; however, the adhesive layer forming device of the present invention is not limited to such a device. For example, when a disc-shaped semiconductor wafer is used, the adhesive layer forming device illustrated in FIG. 1 to FIG. 8 is preferable. However, when a semiconductor wafer having a polygonal shape such as a square is used, an upper cover having such a polygonal shape when viewed from the top may be used as the upper cover and a lower plate including a placing stand and a groove having a shape corresponding to the shape of such an upper cover may be used as the lower plate.

The adhesive layer forming device according to the embodiment of the present invention is configured to include an upper cover and a lower plate that can form a closed space having a specific volume or less, and therefore an open/close door does not have to be provided. This makes it easier to set the semiconductor wafer, form the closed space, reduce pressure in the closed space, desolventize the coating film, release pressure in the closed space, and remove the semiconductor wafer from the closed space, resulting in shortening the "tact time". Furthermore, according to the adhesive layer forming device according to the embodiment of the present invention, when an adhesive composition using polyethylene glycol monomethyl ether acetate having a boiling point of 146°C as a solvent is used, for example, the coating film can be desolventized at 60°C or less under reduced pressure and an adhesive component is less likely to start a polymerization reaction during the desolventization, hence, this makes it possible to shorten the "tact time" and reduce an amount of residual solvent in the adhesive layer. In addition, the adhesive layer forming device according to the embodiment of the present invention has a simple structure, and therefore can be easily incorporated into a semiconductor chip production line.

### [Semiconductor chip production line]

A semiconductor chip production line of according to the embodiment the present invention can be achieved when the adhesive layer forming device according to the embodiment of the present invention is incorporated into a semiconductor chip production line. Note that in the present specification, the semiconductor chip production line including the adhesive layer forming device according to the embodiment of the present invention may be referred to as a "semiconductor chip production line according to the embodiment of the present invention".

The semiconductor chip production line according to the embodiment of the present invention preferably includes, anterior to the adhesive layer forming device according to the embodiment of the present invention, a device (adhesive composition coating device) for coating, on one surface of a semiconductor wafer, an adhesive composition containing an adhesive component and a solvent to form a coating film. In addition, the semiconductor chip production line according to the embodiment of the present invention preferably includes, posterior to the adhesive layer forming device according to the embodiment of the present invention, a device (semiconductor wafer laminating device) for laminating together a semiconductor wafer having an adhesive layer formed thereon and another semiconductor wafer. That is, the semiconductor chip production line according to the embodiment of the present invention preferably includes, in order, an adhesive composition coating device, the adhesive layer forming device according to the embodiment of the present invention, and a semiconductor wafer laminating device.

The above-described adhesive composition coating device is a device for coating, on one surface of a semiconductor wafer, an adhesive composition containing an adhesive component and a solvent to form a coating film. As the adhesive composition coating device, a device including a known or commonly used coater can be used, and, in particular, a device including a spin coater is preferable.

After a coating film is formed on the surface of the semiconductor wafer by coating an adhesive composition by using the adhesive composition coating device, the semiconductor wafer is conveyed to the adhesive layer forming device according to the embodiment of the present invention by conveying means, and then the coating film is desolventized to form an adhesive layer by the adhesive layer forming device according to the embodiment of the present invention. The semiconductor wafer having the adhesive layer formed thereon is then conveyed by the conveying means to the semiconductor wafer laminating device.

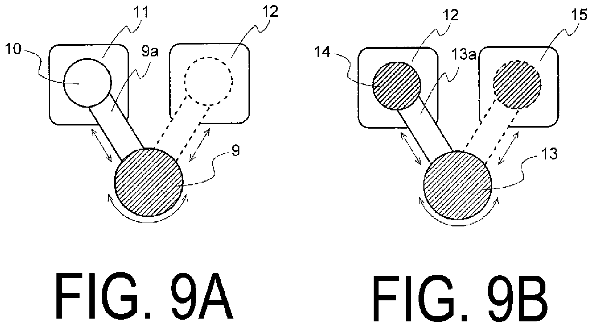

FIG. 9 illustrates a schematic view (top view) of an example in which conveying means is incorporated into the semiconductor chip production line according to the embodiment of the present invention including an adhesive composition coating device, the adhesive layer forming device according to the embodiment of the present invention, and a semiconductor wafer laminating device in this order. FIG. 9A is a schematic view (top view) illustrating a mode before and after conveying, by conveying means, a semiconductor wafer from the adhesive composition coating device to the adhesive layer forming device according to the embodiment of the present invention, and FIG. 9B is a schematic view (top view) illustrating a mode before and after conveying, by the conveying means, the semiconductor wafer from the adhesive layer forming device according to the embodiment of the present invention to the semiconductor wafer laminating device. Note that arrows in the figure indicate moving directions, and portions illustrated with dashed lines indicate a state after the semiconductor wafer is conveyed.

In FIG. 9A, conveying means 9 extends an arm 9a to pick up a semiconductor wafer 10 having a coating film formed thereon on an adhesive composition coating device 11, and then rotates to position the semiconductor wafer 10 above an adhesive layer forming device 12 of the present invention and places the semiconductor wafer 10 on the adhesive layer forming device 12 of the present invention. Thereafter, the conveying means 9 returns to a position to pick up a semiconductor wafer 10 having the coating film formed thereon on the adhesive composition coating device 11.

In FIG. 9B, conveying means 13 extends an arm 13a to pick up a semiconductor wafer 14 having the adhesive layer formed thereon on the adhesive layer forming device 12 of the present invention, and then rotates to position the semiconductor wafer 14 above a semiconductor wafer laminating device 15 and places the semiconductor wafer 14 on the semiconductor wafer laminating device 15. Thereafter, the conveying means 13 returns to a position to pick up a semiconductor wafer 14 having the adhesive layer formed thereon on the adhesive layer forming device 12 of the present invention.

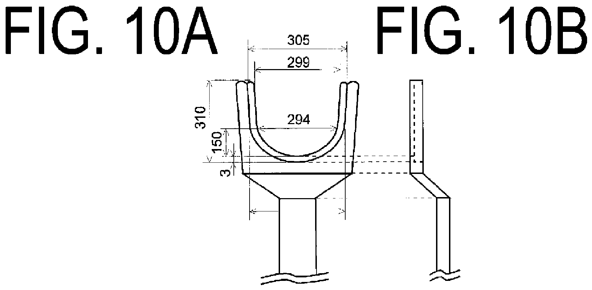

When the conveying means 9 picks up and then places the semiconductor wafer 10, and when the conveying means 13 picks up and then places the semiconductor wafer 14, a pickup jig illustrated in FIG. 10 can be used. FIG. 10A illustrates a top view of the pickup jig and FIG. 10B illustrates a left side view thereof. Note that each numerical value indicated in FIG. 10 represents a distance (mm) of each portion, and is a preferable numerical value for conveying a disc-shaped semiconductor wafer having a diameter of 300 mm. Therefore, the conveying means 9 and 13 each preferably include, at the tip of arm thereof, a pickup jig illustrated in FIG. 10 (a pickup jig having a distance indicated in the figure when the semiconductor wafer is disc-shaped with a diameter of 300 mm). The distance of each portion indicated in FIG. 10 may be changed as appropriate depending on the size of the semiconductor wafer to be conveyed. In addition, when the semiconductor wafer is conveyed manually, a pickup jig in FIG. 10 that has a grip may be used.

The adhesive layer forming device according to the embodiment of the present invention and the semiconductor chip production line according to the embodiment of the present invention are devices for producing various semiconductor elements, such as a memory and an arithmetic element, but can also be used for forming a coating film that is coated to a board-like substrate, a wafer substrate, or a disk shaped substrate.

### [Method for producing laminate]

In the present invention, a method for producing a laminate having an adhesive layer on at least one surface of a semiconductor wafer includes: coating, on one surface of a semiconductor wafer, an adhesive composition containing an adhesive component and a solvent to form a coating film; and forming an adhesive layer by removing (desolventizing) a solvent in the coating film in a closed space having a volume of 10 liters or less under reduced pressure. Note that in the present specification, the method for producing a laminate may be simply referred to as "production method of the present invention".

The above-described semiconductor wafer is a board-like wafer, and may be made of any of silicon, glass, or plastic.

An adhesive composition used in the coating, on one surface of the semiconductor wafer, an adhesive composition containing an adhesive component and a solvent to form a coating film (sometimes referred to as "adhesive composition coating process") includes an adhesive component and a solvent. The adhesive component contained in the adhesive composition is not particularly limited, and an example thereof includes a known or commonly used adhesive component to be used for bonding semiconductor wafers. According to the production method of the present invention, curing of the adhesive layer is less likely to occur during the process of heating and removing the dissolvent performed in the forming an adhesive layer, so it is possible to use a thermosetting adhesive component (particularly an adhesive component that cures at a low temperature (particularly 100°C or lower)) as the adhesive component.

Examples of the adhesive component include polyorganosilsesquioxanes, such as polyorganosilsesquioxane having a group containing an epoxy group on a silicon atom in the constituent unit of silsesquioxane included in the polyorganosilsesquioxane.

The solvent contained in the adhesive composition is not particularly limited, and an example thereof includes an organic solvent to be used in a known or commonly used semiconductor wafer adhesive. According to the production method of the present invention, it is possible to accelerate the desolventization and shorten the "tact time" while occurrence of curing in the adhesive is made infrequent in the forming an adhesive layer, hence, the solvent is preferably an organic solvent having a boiling point of greater than 100°C (for example, greater than 100°C but 200°C or lower) under atmospheric pressure condition, and more preferably is an organic solvent having a boiling point of 110 to 170°C. Examples of such an organic solvent include toluene (boiling point: 110°C), polyethylene glycol methyl ether acetate (boiling point: 146°C), cyclohexanone (boiling point: 156°C), mesitylene (boiling point: 165°C), and the like.

In a method for coating the above-described adhesive composition on at least one surface of the semiconductor wafer, a known or commonly used coater can be used, and, in particular, a spin coater is preferable.

In the forming an adhesive layer by removing the solvent in a closed space having a volume of 10 liters or less under reduced pressure (sometimes referred to as "adhesive layer forming process"), an adhesive layer is formed by desolventizing a coating film formed on the semiconductor wafer. In the adhesive layer forming process, the adhesive layer is preferably formed by using the adhesive layer forming device according to the embodiment of the present invention described above.

The volume of the closed space is 10 liters or less (for example, 0.1 to 10 liters) as described above, preferably 8 liters or less (for example, 0.1 to 8 liters), and more preferably 7 liters or less (for example, 0.1 to 7 liters).

The coating film is preferably desolventized by being heated as necessary under reduced pressure. The pressure under the above-described reduced pressure, that is, the pressure in the closed space during the desolventization is not particularly limited, but 0 to 300 mmHg is preferable, more preferably 0 to 150 mmHg, and even more preferably 0 to 100 mmHg. When the pressure is within the aforementioned range, the desolventization (in particular, removal of the organic solvent having a boiling point within the aforementioned range) can be carried out with high efficiency while occurrence of curing of the adhesive is made infrequent.

The coating film is preferably desolventized at a temperature where the coating film becomes 80°C or less (preferably 60°C or less) for 0.5 to 60 minutes (preferably 2 to 30 minutes).

After the desolventization under the aforementioned reduced pressure is completed, the pressure in the closed space is returned to ordinary pressure, whereby the adhesive layer is formed.

The production method of the present invention may include a process (other processes) other than the adhesive composition applying process and the adhesive layer forming process. Examples of the other processes include laminating a semiconductor wafer having the adhesive layer formed thereon together with another semiconductor wafer (semiconductor wafer laminating process) and the like. As a result, a laminated semiconductor chip having multilayered semiconductor wafers can be produced.

### Examples

Hereinafter, the present invention will be described in more detail based on examples, but the present invention is not limited by these examples.

### Example 1

### (Adhesive layer forming device)

An adhesive layer forming device was provided by assembling, as illustrated in FIG. 4, the upper cover illustrated in FIG. 2 (r1 curvature radius: R = 32, r2 curvature radius: R = 320, w1: 320 mm, w2: 25 mm, h: 80 mm) having a gas inflow guard (bottom area: 25 cm²) at the inner side of the hole, and the lower plate illustrated in FIG. 3 (w3: 400 mm, w4: 400 mm, w5: 294 mm, w6: 310 mm, w7: 32.5 mm, h2: 15 mm, h3: 2 mm). Note that as heating means, a heating plate is provided below the lower plate.

### (1) Time required to reach reduced pressure

In the adhesive layer forming device, the upper cover was lowered until contacting the lower plate (i.e., until the flange part came into contact with the groove) to form a closed space (having a volume of about 6 liters), and the reduction of pressure in the closed space was started by pressure reducing means coupled through a spiral tube and a branch pipe. Then, a time (time for reducing pressure) from the start of reducing pressure until pressure in the closed space reached 100 mmHg or less was measured. As a result, the time for reducing pressure was 10 seconds.

### (2) Presence or absence of leak

The pressure in the closed space was set to 100 mmHg or less, and in this state, the pressure reduction by the pressure reducing means was stopped and left unattended for one hour, and then a change in pressure in the closed space was measured. As a result, there was no change in pressure in the closed space, and the absence of a leak (air leakage into the closed space) was confirmed.

### (3) Time for releasing pressure

Release of the pressure in the closed space was started by using pressure releasing means coupled through a spiral tube and a branch pipe, and a time (time for releasing pressure) taken until the pressure in the closed space returned to the ordinary pressure (atmospheric pressure) was measured. As a result, the time for releasing pressure was 10 seconds.

### (4) Formation of adhesive layer

An adhesive composition (solvent concentration: 67.9 wt.%) was produced by dissolving an adhesive (polyorganosilsesquioxane including one having a group containing an epoxy group on a silicon atom as the constituent unit of silsesquioxane) to be used to produce a laminated semiconductor, into a solvent (polyethylene glycol monomethyl ether acetate (boiling point: 146°C)). The obtained adhesive composition was coated to the surface of a disc-shaped semiconductor wafer having a diameter of 300 mm to form a coating film. An adhesive layer was formed by using the adhesive layer forming device described above, in a manner in which a semiconductor wafer was placed on the placing stand of the lower plate heated to a surface temperature of 50°C, the upper cover was lowered to form a closed space, the pressure in the closed space was reduced by the pressure reducing means until the pressure in the closed space reached 100 mmHg or less, and then in this state, the coating film was desolventized for 7 minutes from the start of reducing the pressure (desolventization time: 5 minutes). Then, an amount of dissolvent was analyzed using gas chromatography on a solution in which the formed adhesive layer was dissolved in acetone. As a result, the amount of residual solvent in the adhesive layer was equal to or lower than a detection limit.

### Comparative Example 1

The adhesive composition used in Example 1 was coated to the surface of a disc-shaped semiconductor wafer having a diameter of 300 mm to form a coating film, the resultant film was placed on a hot plate set to the same temperature as that of the lower plate used in Example 1, and the coating film was desolventized for the time same as the desolventization time of Example 1 under atmospheric pressure to form an adhesive layer. Then, the amount of dissolvent was analyzed using gas chromatography under the same conditions as those in Example 1 on the formed adhesive layer. As a result, the amount of residual solvent in the adhesive layer was 0.5 wt.%.

To summarize the above, configurations of the present invention and variations thereof will be described below.
[1] An adhesive layer forming device for forming an adhesive layer by removing a solvent in a coating film coated and formed on one surface of a semiconductor wafer, the device including: a lower plate on which the semiconductor wafer is placed; an upper cover configured to form a closed space together with the lower plate, the closed space having a volume of 10 liters or less; and pressure reducing means for reducing pressure in the closed space.
[2] The adhesive layer forming device according to [1], wherein a portion of the upper cover has a dome shape, the portion serving as a ceiling of the closed space.
[3] The adhesive layer forming device according to [2], wherein a dome shaped part of the upper cover is made of metal and a thickness of the dome shaped part is 2 mm or less.
[4] The adhesive layer forming device according to any one of [1] to [3], including heating means for heating the coating film.
[5] The adhesive layer forming device according to any one of [1] to [4], wherein the upper cover includes a flange part on a circumference of the upper cover, and the lower plate includes a placing stand on which the semiconductor wafer is placed and a groove provided around the placing stand and configured to contact the flange part thereby forming the closed space.
[6] The adhesive layer forming device according to [5], wherein a width of the flange part is 5 to 30 mm, and a width of the groove is greater than the width of the flange part and is 12 to 60 mm.
[7] The adhesive layer forming device according to [5] or [6], wherein a bottom of the flange part and a surface of the groove are subjected, in pair, to surface processing for adherence by lapping.
[8] The adhesive layer forming device according to any one of [1] to [7], including a thermocouple at a position, where ventilation from the closed space is blocked, within the lower plate.
[9] The adhesive layer forming device according to any one of [1] to [8], further including a vertical drive unit including a hook unit and a ball unit, the vertical drive unit configured to move the upper cover vertically to open and close the closed space, wherein the upper cover is coupled to a branch pipe coupled to the pressure reducing means and pressure releasing means for returning pressure in the closed space to ordinary pressure.
[10] The adhesive layer forming device according to [9], wherein the upper cover includes a gas inflow guard configured to prevent gas, which flows into the closed space when the pressure in the closed space is returned to ordinary pressure, from blowing directly against a surface of the formed adhesive layer, the gas inflow guard being provided at an inner side of a portion, where the gas flows in, of the upper cover.
[11] The adhesive layer forming device according to [9] or [10], wherein the hook unit is coupled to a jack via an arm.
[12] A semiconductor chip production line including, in the following order: an adhesive composition coating device for coating, on one surface of the semiconductor wafer, an adhesive composition containing an adhesive component and a solvent thereby forming a coating film; the adhesive layer forming device according to any one of [1] to [11]; and a device configured to laminate together the semiconductor wafer having the adhesive layer formed thereon and another semiconductor wafer.
[13] A method for producing a laminate having an adhesive layer on at least one surface of a semiconductor wafer, the method including: coating, on one surface of a semiconductor wafer, an adhesive composition containing an adhesive component and a solvent to thereby form a coating film; and forming an adhesive layer by removing a solvent in the coating film in a closed space having a volume of 10 liters or less under reduced pressure.
[14] A method for producing a laminate having an adhesive layer on at least one surface of a semiconductor wafer, the method including: coating, on one surface of a semiconductor wafer, an adhesive composition containing an adhesive component and a solvent thereby forming a coating film; and forming an adhesive layer by removing a solvent in the coating film by using the adhesive layer forming device according to any one of [1] to [11].

### Industrial Applicability

The adhesive layer forming device of the present invention can form an adhesive layer interposed between wafers in a wafer laminate obtained by the wafer-on-wafer method (WOW method).

### Reference Signs List

1 Lower plate
1a Placing stand
1b Groove
1c Thermocouple
2 Upper cover
2a Dome shaped part
2b Flange part
2c Hole
2d Gas inflow guard
3 Tube branching unit
3a Unit main body
3b Branch pipe
3c Pipe
3d Tube joint
3e Tube joint
3f Tube joint
4 Vertical drive unit
4a Ball unit
4b Hook unit
4c Cavity
5a Spiral tube coupled to pressure reducing means
5b Spiral tube coupled to pressure releasing means
6a Jack
6b Arm
7a Coating film
7b Semiconductor wafer
7c Adhesive layer
8 Heating plate
9 Conveying means
9a Arm
10 Semiconductor wafer having coating layer coated and formed thereon
11 Adhesive composition coating device
12 Adhesive layer forming device of the present invention
13 Conveying means
13a Arm
14 Semiconductor wafer having adhesive layer formed thereon
15 Semiconductor wafer laminating device

## Claims

1. An adhesive layer forming device for forming an adhesive layer by removing a solvent in a coating film coated and formed on one surface of a semiconductor wafer, the device comprising:
a lower plate on which the semiconductor wafer is placed;
an upper cover configured to form a closed space together with the lower plate, the closed space having a volume of 10 liters or less; and
pressure reducing means for reducing pressure in the closed space.

2. The adhesive layer forming device according to claim 1, wherein
a portion of the upper cover has a dome shape, the portion serving as a ceiling of the closed space.

3. The adhesive layer forming device according to claim 2, wherein
a dome shaped part of the upper cover is made of metal and a thickness of the dome shaped part is 2 mm or less.

4. The adhesive layer forming device according to any one of claims 1 to 3, comprising heating means for heating the coating film.

5. The adhesive layer forming device according to any one of claims 1 to 4, wherein
the upper cover includes a flange part on a circumference of the upper cover, and
the lower plate includes a placing stand on which the semiconductor wafer is placed and a groove provided around the placing stand and configured to contact the flange part thereby forming the closed space.

6. The adhesive layer forming device according to any one of claims 1 to 5, comprising a thermocouple at a position, where ventilation from the closed space is blocked, within the lower plate.

7. The adhesive layer forming device according to any one of claims 1 to 6, further comprising a vertical drive unit including a hook unit and a ball unit, the vertical drive unit being configured to move the upper cover vertically to open and close the closed space, wherein
the upper cover is coupled to a branch pipe coupled to the pressure reducing means and pressure releasing means for returning pressure in the closed space to ordinary pressure.

8. The adhesive layer forming device according to claim 7, wherein
the upper cover includes a gas inflow guard configured to prevent gas, which flows into the closed space when the pressure in the closed space is returned to ordinary pressure, from blowing directly against a surface of the formed adhesive layer, the gas inflow guard being provided at an inner side of a portion, where the gas flows in, of the upper cover.

9. The adhesive layer forming device according to claim 7 or 8, wherein the hook unit is coupled to a jack via an arm.

10. A semiconductor chip production line comprising, in the following order:
an adhesive composition coating device for coating, on one surface of a semiconductor wafer, an adhesive composition containing an adhesive component and a solvent thereby forming a coating film;
the adhesive layer forming device according to any one of claims 1 to 9; and
a device configured to laminate together the semiconductor wafer having the adhesive layer formed thereon and another semiconductor wafer.

11. A method for producing a laminate having an adhesive layer on at least one surface of a semiconductor wafer, the method comprising:
coating, on one surface of a semiconductor wafer, an adhesive composition containing an adhesive component and a solvent thereby forming a coating film; and
forming an adhesive layer by removing a solvent in the coating film in a closed space having a volume of 10 liters or less under reduced pressure.

12. A method for producing a laminate having an adhesive layer on at least one surface of a semiconductor wafer, the method comprising:
coating, on one surface of a semiconductor wafer, an adhesive composition containing an adhesive component and a solvent thereby forming a coating film; and
forming an adhesive layer by removing a solvent in the coating film by using the adhesive layer forming device according to any one of claims 1 to 9.
